# EUROPÄISCHE PATENTANMELDUNG

(11) **EP 1 772 228 A1**
(43) Veröffentlichungstag der Anmeldung: **11.04.2007**
(21) Anmeldenummer: 05021898.1
(22) Anmeldetag: 07.10.2005
(51) Int. Cl.: B23P 6/04, C30B 33/00

(54) **Verfahren zum Reparieren eines Bauteils mit einer gerichteten Mikrostruktur**

(71) Anmelder: SIEMENS AKTIENGESELLSCHAFT, 80333 München (DE)
(72) Erfinder: Jabado, Rene, 14199 Berlin (DE); Jensen, Jens, Dahl, Dr., 14050 Berlin (DE); Krüger, Ursus, Dr., 14089 Berlin (DE); Körtvelyessy, Daniel, 13469 Berlin (DE); Reiche, Ralph, 13465 Berlin (DE); Rindler, Michael, 15566 Schöneiche (DE)

(57) **Zusammenfassung**

Ein Verfahren zum Reparieren eines Bauteils (406), insbesondere eines Gasturbinenbauteils, welches aus einem Basismaterial mit einer gerichteten Mikrostruktur hergestellt ist, umfasst die Schritte:
- Reinigen der Reparaturstelle (420),
- Füllen der Reparaturstelle (420) mit einem der Zusammensetzung des Basiswerkstoffes entsprechenden Füllmaterial,
- Durchführen einer Wärmebehandlung im Bereich der gefüllten Reparaturstelle (420), wobei
- das Füllmaterial mikro- und/oder nanoskalige Partikel (425a, 425b) aufweist,
- beim Füllen der Reparaturstelle (420) Maßnahmen getroffen sind, welche die Oxidation des Füllmaterials verhindern, und
- die Temperaturen und Haltezeiten der Wärmebehandlung derart auf die Zusammensetzung des Füllmaterials und des Basismaterials des Bauteils (406) abgestimmt sind, dass eine epitaktische Anbindung des Füllmaterials an das umgebende Basismaterial erfolgt.

## Beschreibung

Die vorliegende Erfindung betrifft ein Verfahren zum Reparieren eines Bauteils, insbesondere eines Gasturbinenbauteils, welches aus einem Basismaterial mit einer gerichteten Mikrostruktur hergestellt ist.

Maschinenbauteile, welche im Betrieb hohen Belastungen ausgesetzt sind, wie etwa Turbinenbauteile, werden heutzutage unter anderem aus Materialien mit einer gerichteten Mikrostruktur hergestellt. Diese Materialien zeichnen sich durch eine hohe Widerstandsfähigkeit gegenüber thermischen und mechanischen Belastungen aus. Als Materialien mit gerichteter Mikrostruktur sind insbesondere einkristalline Materialien und solche Materialien anzusehen, die eine Kornstruktur aufweisen, in der die Ausdehnung der Körner eine allen Körnern gemeinsame Vorzugsrichtung besitzt. Bauteile mit der beschriebenen Kornstruktur werden als direktional erstarrt (directional solidified) bezeichnet. Die einkristallinen Materialien werden auch SX-Materialien und die direktional erstarrten Materialien als DX-Materialien bezeichnet.

Wenn die Bauteile im Betrieb einer hohen thermischen und mechanischen Beanspruchung ausgesetzt sind, kann es trotz der gerichteten Mikrostruktur zu Materialermüdungen und infolgedessen zu Rissen kommen. Man ist bestrebt, Bauteile mit Rissen zu reparieren, da das Herstellen von Bauteilen aus Basismaterialien mit einer gerichteten Mikrostruktur kostspielig ist. Dabei ist darauf zu achten, dass das reparierte Bauteil den thermischen und mechanischen Beanspruchungen im weiteren Einsatz hinreichend widerstehen kann.

Ein gängiges Verfahren zum Reparieren beschädigter Bauteile ist bspw. das Löten. Bei diesem Löten wird ein Lot im Bereich des Risses auf das Material des Bauteils aufgebracht und mittels Wärmeinwirkung mit dem Basismaterial verbunden. Nach dem Löten weist das Lotmaterial jedoch keine einkristalline oder direktional erstarrte Struktur auf. Eine ungerichtete Mikrostruktur besitzt jedoch im Vergleich zu einer gerichteten Mikrostruktur schlechtere Materialeigenschaften - vor allem im Hochtemperaturbereich -, sodass die Lötstelle eine Schwachstelle des Bauteils darstellt. Zum Reparieren von geschädigten Bauteilen mit einer gerichteten Mikrostruktur stehen Schweißverfahren zur Verfügung, mit denen auch in den verschweißten Bereichen eine gerichtete Mikrostruktur geschaffen werden kann. Ein derartiges Verfahren ist bspw. in EP 0 892 090 A1 offenbart.

Weitere Verfahren bzw. zu verwendende Lotpulver sind bekannt aus der US 6,283,356, US 4,705,203, US 4,900,394, US 6,565,678, US 4,830,934, US 4,878,953, US 5,666,643, US 6,454,885, US 6,503,349, US 5,523,170, US 4,878,953, US 4,987,736, US 5,806,751, US 5,783,318, US 5,873,703.

Die Entwicklung von Lötanwendungen für Bauteile aus direktional gerichteten Werkstoffen, insbesondere aus Einkristallwerkstoffen, birgt die Gefahr der Rekristallisierung während der Wärmebehandlung in sich, da die Lötanwendung eine Temperatur nahe dem Schmelzpunkt des direktional gerichteten Werkstoffes erfordert.

Die Reparatur von direktional gerichteten Werkstoffen und insbesondere von Einkristallwerkstoffen ist in den vergangenen Jahren daher zumeist durch Schweißanwendungen, bspw. mittels eines Lasers, realisiert worden. Hierbei besteht eine große Herausforderung darin, die Kornausrichtung weiterzuführen, damit keine Schwachstellen entstehen können. Zudem leiten alle Scheißanwendungen lokale große Wärmemengen in den Werkstoff und führen daher bedingt durch den entstehenden Temperaturgradienten zu Spannungen im Werkstoff. Diese Spannungen können selbst zu Rissen führen, was den Effekt der Reparatur zu Nichte macht.

Gegenüber dem genannten Stand der Technik ist es Aufgabe der vorliegenden Erfindung, ein verbessertes Verfahren zum Reparieren eines Bauteils aus einem Basismaterial mit einer gerichteten Mikrostruktur, insbesondere eines Turbinenbauteils zur Verfügung zu stellen.

Diese Aufgabe wird durch ein Verfahren zum Reparieren eines Bauteils nach Anspruch 1 gelöst. Die abhängigen Ansprüche enthalten vorteilhafte Ausgestaltungen der Erfindung.

Das erfindungsgemäße Verfahren zum Reparieren eines Bauteils, welches aus einem Basismaterial mit einer gerichteten Mikrostruktur hergestellt ist, umfasst die Schritte: Reinigen der Reparaturstelle, Füllen der Reparaturstelle mit einem der Zusammensetzung des Basiswerkstoffes entsprechenden Füllmaterial und Durchführen einer Wärmebehandlung im Bereich der gefüllten Reparaturstelle. Das zu reparierende Bauteil kann insbesondere ein Gasturbinenbauteil, bspw. eine Turbinenschaufel, sein. Im erfindungsgemäßen Verfahren weist das Füllmaterial mikro- und/oder nanoskalige Partikel auf. Zudem sind beim Füllen der Reparaturstelle Maßnahmen getroffen, welche die Oxidation des Füllmaterials verhindern. Schließlich sind die Temperaturen und Haltezeiten der Wärmebehandlung derart gewählt, dass die Reparaturstelle dieselbe gerichtete Mikrostruktur wie das die Reparaturstelle umgebende Basismaterial aufweist. Die gerichtete Mikrostruktur lässt sich insbesondere dadurch herbeiführen, dass die Temperatur der Wärmebehandlung unterhalb der Schmelztemperatur des Basismaterials liegt und die Abkühlung eine bestimmte Abkühlungsrate nicht überschreitet. Eine zu hohe Abkühlungsrate würde das geordnete Wachsen und damit die Ausbildung einer gerichteten Mikrostruktur im in der Reparaturstelle stören. Die jeweils einzuhaltenden Temperaturen und Abkühlungsraten hängen u. a. vom Basismaterial ab, so dass sie für verschiedene Basismaterialien unterschiedlich sein können. Geeignete Abkühlungsraten können insbesondere empirisch ermittelt werden.

Mit dem erfindungsgemäßen Verfahren können Risse in Bauteilen aus direktional gerichteten Werkstoffen derart strukturell repariert werden, dass die Reparaturstelle dieselbe gerichtete Mikrostruktur aufweist und ohne dass die Eigenschaften des umgebenden Basismaterials negativ beeinflusst werden. Aufgrund der Verwendung mikro- und/oder nanoskaliger Partikel ist die Schmelztemperatur des Füllmaterials gegenüber der Schmelztemperatur des umgebenden Basismaterials herabgesetzt. Die Wärmebehandlung kann daher mit Temperaturen erfolgen, welche niedriger sind als die Temperaturen in einem Lötverfahren. Auch fallen lokal nicht so hohe Wärmemengen an, wie bei dem eingangs beschriebenen Schweißverfahren.

Zum Füllen der Reparaturstelle kann ein Spritzverfahren zur Anwendung kommen, welches eine niedrige Temperatur der verspritzten Partikel ermöglicht. Denkbar ist bspw. die Anwendung eines Niedertemperatur-Hochgeschwindigkeits-Flammenspritz-Verfahrens, wie es bspw. in DE 102 53 794 A1 beschrieben ist. Vorzugsweise kommt zum Füllen der Reparaturstelle jedoch ein Kaltgas-Spritz-Verfahren, wie es bspw. in DE 102 24 780 A1 beschrieben ist, zur Anwendung. Beim Niedertemperatur-Flammenspritzen kann die Oxidation der verspritzten Partikel weitgehend unterdrückt werden. Beim Kaltgas-Spritzen, in dem Spritzpartikel von einem "kalten" Gasstrahl auf hohe Geschwindigkeiten beschleunigt werden, ist sogar eine noch weiter gehende Unterdrückung der Oxidation möglich, sodass praktisch gar keine Oxidation der verspritzten Partikel stattfindet.

Da Partikel mit Durchmessern von weniger als ca. 5 µm mittels Kaltgas-Spritzverfahren nicht ohne Weiteres direkt verspritzt werden können, sind in einer vorteilhaften Ausgestaltung der Erfindung die Partikel beim Füllen der Reparaturstelle von einer Hülle umgeben. Die Hülle, die aus einem Materialbestandteil des Basismaterials, bspw. Nickel oder Kobalt, aufgebaut sein kann, vergrößert die Dimension der Partikel. Auf Grund der vergrößerten Abmessung können die Partikel vom Kaltgasstrom besser mitgerissen und beschleunigt werden. Die beim Auftreffen auf die Wände der Füllstelle in Wärme umgewandelte kinetische Energie führt dabei zu einem Anschmelzen des Füllmaterials. Um während des Spritzens diejenigen Bereiche, welche die Reparaturstelle umgeben, zu schützen, können diese beim Füllen mit einer Blende abgedeckt werden.

In einer vorteilhaften Ausgestaltung des erfindungsgemäßen Verfahrens liegt das Füllmaterial in Form mindestens zweier Bestandteile vor, welche ein eutektisches Mischungsverhältnis aufweisen. Ein eutektisches Mischungsverhältnis ist ein Mischungsverhältnis, welches dazu führt, dass sich aus einer Schmelze der Materialzusammensetzung beim Abkühlen nur Mischkristalle bilden. Ein vom eutektischen Mischungsverhältnis abweichendes Mischungsverhältnis führt hingegen dazu, dass sich beim Abkühlen reine Kristalle der beiden Materialbestandteile bilden. Zudem zeichnet sich das eutektische Mischungsverhältnis dadurch aus, dass es die niedrigste Schmelztemperatur aller Mischungsverhältnisse der beiden Materialbestandteile aufweist. Im erfindungsgemäßen Verfahren bietet dies insbesondere den Vorteil, dass die Wärmebehandlung mit besonders niedrigen Temperaturen durchgeführt werden kann.

Der Reinigungsprozess vor dem Füllen der Reparaturstelle sollte vorzugsweise derart erfolgen, dass eventuell vorhandene Oxide vollständig von der zu reparierenden Stelle entfernt werden.

Mit dem erfindungsgemäßen Verfahren können insbesondere die Rissenden beim Reparieren von Rissen im Basismaterial eines Bauteils gefüllt werden. Das Füllen der Rissenden ist mit größeren Partikeln nicht ohne weiteres möglich. Das Füllen der Rissenden ist aber von großer Bedeutung, da durch das Reparieren insbesondere der Rissenden eine Verlängerung der Risse wirksam unterbunden werden kann. Das Volumen der Risse kann dann gegebenenfalls auch mit größeren als den mikro- und/oder nanoskaligen Partikeln erfolgen.

Weitere Merkmale, Eigenschaften und Vorteile der vorliegenden Erfindung ergeben sich aus der nachfolgenden Beschreibung eines Ausführungsbeispiels unter Bezugnahme auf die beiliegenden Figuren.
- Fig. 1: zeigt beispielhaft eine Gasturbine in einem Längsteilschnitt
- Fig. 2: zeigt in perspektivischer Ansicht eine Laufschaufel oder Leitschaufel einer Strömungsmaschine
- Fig. 3: zeigt eine Brennkammer einer Gasturbine
- Figur 4: zeigt in einer schematischen Darstellung einen Ausschnitt aus einer Turbinenschaufel mit einem Riss
- Figur 5: zeigt in einer schematischen Darstellung den Riss in einer geschnittenen Seitenansicht
- Figur 6: zeigt das Füllen des Risses aus Figur 5
- Figur 7: zeigt den gefüllten Riss nach dem Durchführen einer Wärmebehandlung
- Figur 8: zeigt ein Teilchenagglomerat, wie es zum Füllen des Risses Verwendung findet

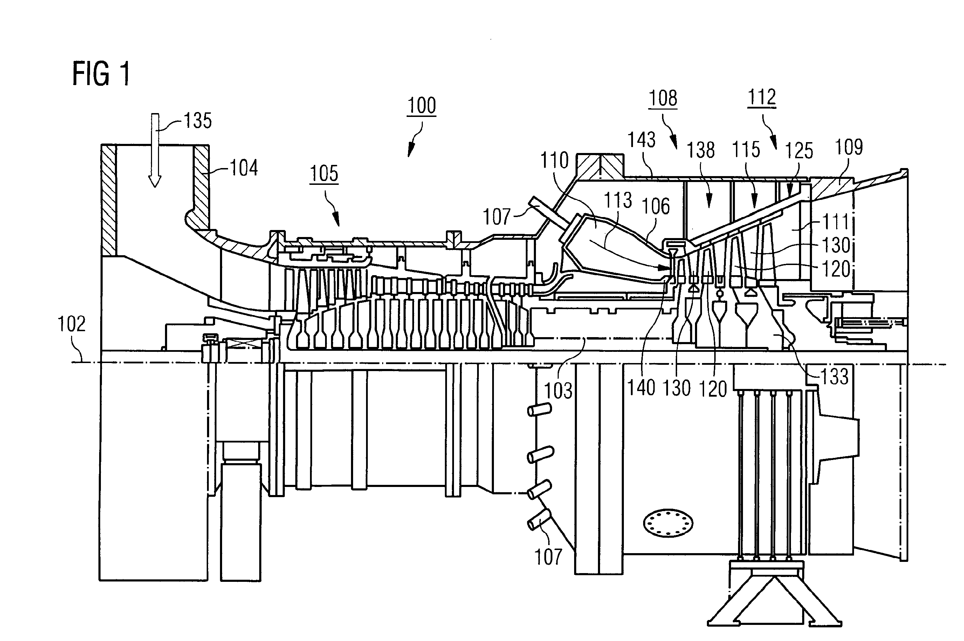

Die Figur 1 zeigt beispielhaft eine Gasturbine 100 in einem Längsteilschnitt. Die Gasturbine 100 weist im Inneren einen um eine Rotationsachse 102 drehgelagerten Rotor 103 auf, der auch als Turbinenläufer bezeichnet wird. Entlang des Rotors 103 folgen aufeinander ein Ansauggehäuse 104, ein Verdichter 105, eine beispielsweise torusartige Brennkammer 110, insbesondere Ringbrennkammer 106, mit mehreren koaxial angeordneten Brennern 107, eine Turbine 108 und das Abgasgehäuse 109.

Die Ringbrennkammer 106 kommuniziert mit einem beispielsweise ringförmigen Heißgaskanal 111. Dort bilden beispielsweise vier hintereinandergeschaltete Turbinenstufen 112 die Turbine 108.

Jede Turbinenstufe 112 ist beispielsweise aus zwei Schaufelringen gebildet. In Strömungsrichtung eines Arbeitsmediums 113 gesehen folgt im Heißgaskanal 111 einer Leitschaufelreihe 115 eine aus Laufschaufeln 120 gebildete Reihe 125.

Die Leitschaufeln 130 sind dabei an einem Innengehäuse 138 eines Stators 143 befestigt, wohingegen die Laufschaufeln 120 einer Reihe 125 beispielsweise mittels einer Turbinenscheibe 133 am Rotor 103 angebracht sind.

An dem Rotor 103 angekoppelt ist ein Generator oder eine Arbeitsmaschine (nicht dargestellt).

Während des Betriebes der Gasturbine 100 wird vom Verdichter 105 durch das Ansauggehäuse 104 Luft 135 angesaugt und verdichtet. Die am turbinenseitigen Ende des Verdichters 105 bereitgestellte verdichtete Luft wird zu den Brennern 107 geführt und dort mit einem Brennmittel vermischt. Das Gemisch wird dann unter Bildung des Arbeitsmediums 113 in der Brennkammer 110 verbrannt. Von dort aus strömt das Arbeitsmedium 113 entlang des Heißgaskanals 111 vorbei an den Leitschaufeln 130 und den Laufschaufeln 120. An den Laufschaufeln 120 entspannt sich das Arbeitsmedium 113 impulsübertragend, so dass die Laufschaufeln 120 den Rotor 103 antreiben und dieser die an ihn angekoppelte Arbeitsmaschine.

Die dem heißen Arbeitsmedium 113 ausgesetzten Bauteile unterliegen während des Betriebes der Gasturbine 100 thermischen Belastungen. Die Leitschaufeln 130 und Laufschaufeln 120 der in Strömungsrichtung des Arbeitsmediums 113 gesehen ersten Turbinenstufe 112 werden neben den die Ringbrennkammer 106 auskleidenden Hitzeschildsteinen am meisten thermisch belastet.

Um den dort herrschenden Temperaturen standzuhalten, können diese mittels eines Kühlmittels gekühlt werden.

Ebenso können Substrate der Bauteile eine gerichtete Struktur aufweisen, d.h. sie sind einkristallin (SX-Struktur) oder weisen nur längsgerichtete Körner auf (DS-Struktur).

Als Material für die Bauteile, insbesondere für die Turbinenschaufel 120, 130 und Bauteile der Brennkammer 110 werden beispielsweise eisen-, nickel- oder kobaltbasierte Superlegierungen verwendet. Solche Superlegierungen sind beispielsweise aus der EP 1 204 776 B1, EP 1 306 454, EP 1 319 729 A1, WO 99/67435 oder WO 00/44949 bekannt; diese Schriften sind Teil der Offenbarung.

Ebenso können die Schaufeln 120, 130 Beschichtungen gegen Korrosion (MCrAlX; M ist zumindest ein Element der Gruppe Eisen (Fe), Kobalt (Co), Nickel (Ni), X ist ein Aktivelement und steht für Yttrium (Y) und/oder Silizium und/oder zumindest ein Element der Seltenen Erden bzw. Hafnium). Solche Legierungen sind bekannt aus der EP 0 486 489 B1, EP 0 786 017 B1, EP 0 412 397 B1 oder EP 1 306 454 A1, die Teil dieser Offenbarung sein sollen.

Auf der MCrAlX kann noch eine Wärmedämmschicht vorhanden sein, und besteht beispielsweise aus ZrO₂, Y₂O₃-ZrO₂, d.h. sie ist nicht, teilweise oder vollständig stabilisiert durch Yttriumoxid und/oder Kalziumoxid und/oder Magnesiumoxid.
Durch geeignete Beschichtungsverfahren wie z.B. Elektronenstrahlverdampfen (EB-PVD) werden stängelförmige Körner in der Wärmedämmschicht erzeugt.

Die Leitschaufel 130 weist einen dem Innengehäuse 138 der Turbine 108 zugewandten Leitschaufelfuß (hier nicht dargestellt) und einen dem Leitschaufelfuß gegenüberliegenden Leitschaufelkopf auf. Der Leitschaufelkopf ist dem Rotor 103 zugewandt und an einem Befestigungsring 140 des Stators 143 festgelegt.

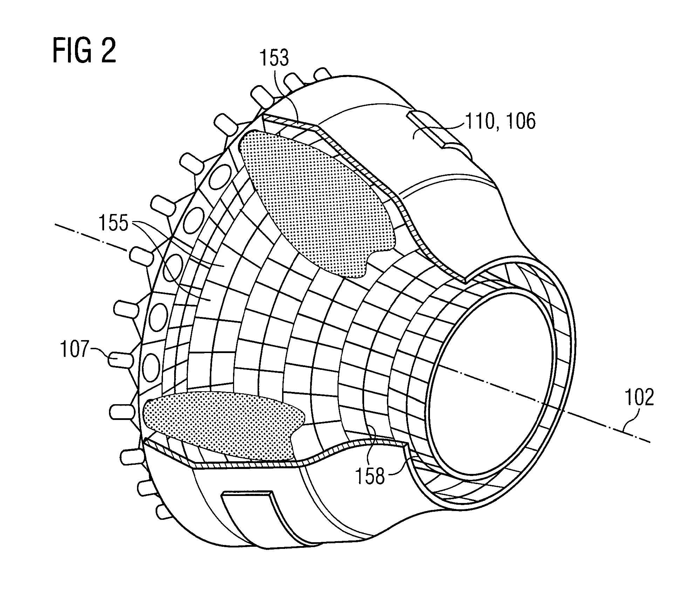

Figur 2 zeigt in perspektivischer Ansicht eine Laufschaufel 120 oder Leitschaufel 130 einer Strömungsmaschine, die sich entlang einer Längsachse 121 erstreckt.

Die Strömungsmaschine kann eine Gasturbine eines Flugzeugs oder eines Kraftwerks zur Elektrizitätserzeugung, eine Dampfturbine oder ein Kompressor sein.

Die Schaufel 120, 130 weist entlang der Längsachse 121 aufeinander folgend einen Befestigungsbereich 400, eine daran angrenzende Schaufelplattform 403 sowie ein Schaufelblatt 406 auf. Als Leitschaufel 130 kann die Schaufel 130 an ihrer Schaufelspitze 415 eine weitere Plattform aufweisen (nicht dargestellt).

Im Befestigungsbereich 400 ist ein Schaufelfuß 183 gebildet, der zur Befestigung der Laufschaufeln 120, 130 an einer Welle oder einer Scheibe dient (nicht dargestellt).
Der Schaufelfuß 183 ist beispielsweise als Hammerkopf ausgestaltet. Andere Ausgestaltungen als Tannenbaum- oder Schwalbenschwanzfuß sind möglich.

Die Schaufel 120, 130 weist für ein Medium, das an dem Schaufelblatt 406 vorbeiströmt, eine Anströmkante 409 und eine Abströmkante 412 auf.

Bei herkömmlichen Schaufeln 120, 130 werden in allen Bereichen 400, 403, 406 der Schaufel 120, 130 beispielsweise massive metallische Werkstoffe, insbesondere Superlegierungen verwendet. Solche Superlegierungen sind beispielsweise aus der EP 1204776 B1, EP 1306454, EP 1319729 A1, WO 99/67435 oder WO 00/44949 bekannt; diese Schriften sind Teil der Offenbarung. Die Schaufel 120, 130 kann hierbei durch ein Gussverfahren, auch mittels gerichteter Erstarrung, durch ein Schmiedeverfahren, durch ein Fräsverfahren oder Kombinationen daraus gefertigt sein.

Werkstücke mit einkristalliner Struktur oder Strukturen werden als Bauteile für Maschinen eingesetzt, die im Betrieb hohen mechanischen, thermischen und/oder chemischen Belastungen ausgesetzt sind. Die Fertigung von derartigen einkristallinen Werkstücken erfolgt z.B. durch gerichtetes Erstarren aus der Schmelze. Es handelt sich dabei um Gießverfahren, bei denen die flüssige metallische Legierung zur einkristallinen Struktur, d.h. zum einkristallinen Werkstück, oder gerichtet erstarrt. Dabei werden dendritische Kristalle entlang dem Wärmefluss ausgerichtet und bilden entweder eine stängelkristalline Kornstruktur (kolumnar, d.h. Körner, die über die ganze Länge des Werkstückes verlaufen und hier, dem allgemeinen Sprachgebrauch nach, als gerichtet erstarrt bezeichnet werden) oder eine einkristalline Struktur, d.h. das ganze Werkstück besteht aus einem einzigen Kristall. In diesen Verfahren muss man den Übergang zur globulitischen (polykristallinen) Erstarrung meiden, da sich durch ungerichtetes Wachstum notwendigerweise transversale und longitudinale Korngrenzen ausbilden, welche die guten Eigenschaften des gerichtet erstarrten oder einkristallinen Bauteiles zunichte machen. Ist allgemein von gerichtet erstarrten Gefügen die Rede, so sind damit sowohl Einkristalle gemeint, die keine Korngrenzen oder höchstens Kleinwinkelkorngrenzen aufweisen, als auch Stängelkristallstrukturen, die wohl in longitudinaler Richtung verlaufende Korngrenzen, aber keine transversalen Korngrenzen aufweisen. Bei diesen zweitgenannten kristallinen Strukturen spricht man auch von gerichtet erstarrten Gefügen (directionally solidified structures). Solche Verfahren sind aus der US-PS 6,024,792 und der EP 0 892 090 A1 bekannt; diese Schriften sind Teil der Offenbarung.

Ebenso können die Schaufeln 120, 130 Beschichtungen gegen Korrosion oder Oxidation (MCrA1X; M ist zumindest ein Element der Gruppe Eisen (Fe), Kobalt (Co), Nickel (Ni), X ist ein Aktivelement und steht für Yttrium (Y) und/oder Silizium und/oder zumindest ein Element der Seltenen Erden, bzw. Hafnium (Hf)). Solche Legierungen sind bekannt aus der EP 0 486 489 B1, EP 0 786 017 B1, EP 0 412 397 B1 oder EP 1 306 454 A1, die Teil dieser Offenbarung sein sollen.

Auf der MCrAlX kann noch eine Wärmedämmschicht vorhanden sein und besteht beispielsweise aus ZrO₂, Y₂O₃-ZrO₂, d.h. sie ist nicht, teilweise oder vollständig stabilisiert durch Yttriumoxid und/oder Kalziumoxid und/oder Magnesiumoxid. Durch geeignete Beschichtungsverfahren wie z.B. Elektronenstrahlverdampfen (EB-PVD) werden stängelförmige Körner in der Wärmedämmschicht erzeugt.

Wiederaufarbeitung (Refurbishment) bedeutet, dass Bauteile 120, 130 nach ihrem Einsatz gegebenenfalls von Schutzschichten befreit werden müssen (z.B. durch Sandstrahlen). Danach erfolgt eine Entfernung der Korrosions- und/oder Oxidationsschichten bzw. -produkte. Gegebenenfalls werden auch noch Risse im Bauteil 120, 130 repariert. Danach erfolgt eine Wiederbeschichtung des Bauteils 120, 130 und ein erneuter Einsatz des Bauteils 120, 130.

Die Schaufel 120, 130 kann hohl oder massiv ausgeführt sein. Wenn die Schaufel 120, 130 gekühlt werden soll, ist sie hohl und weist ggf. noch Filmkühllöcher 418 (gestrichelt angedeutet) auf.

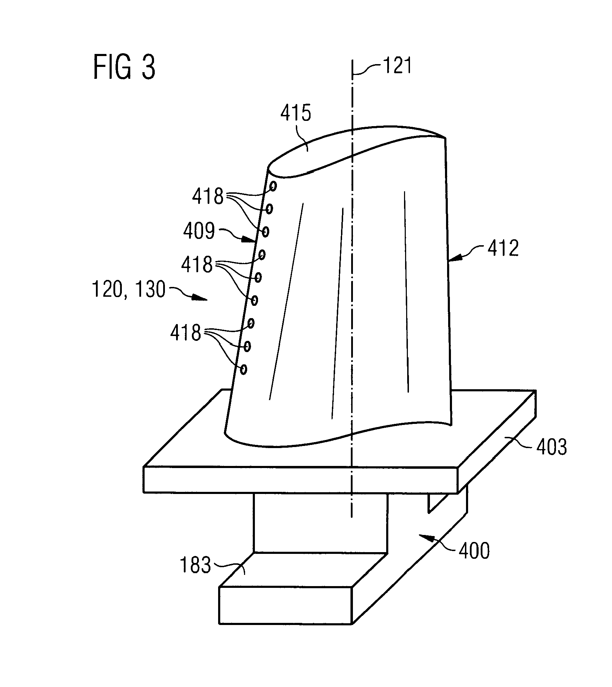

Die Figur 3 zeigt eine Brennkammer 110 einer Gasturbine. Die Brennkammer 110 ist beispielsweise als so genannte Ringbrennkammer ausgestaltet, bei der eine Vielzahl von in Umfangsrichtung um die Rotationsachse 102 herum angeordneten Brennern 107 in einen gemeinsamen Brennkammerraum münden. Dazu ist die Brennkammer 110 in ihrer Gesamtheit als ringförmige Struktur ausgestaltet, die um die Rotationsachse 102 herum positioniert ist.

Zur Erzielung eines vergleichsweise hohen Wirkungsgrades ist die Brennkammer 110 für eine vergleichsweise hohe Temperatur des Arbeitsmediums M von etwa 1000°C bis 1600°C ausgelegt. Um auch bei diesen, für die Materialien ungünstigen Betriebsparametern eine vergleichsweise lange Betriebsdauer zu ermöglichen, ist die Brennkammerwand 153 auf ihrer dem Arbeitsmedium M zugewandten Seite mit einer aus Hitzeschildelementen 155 gebildeten Innenauskleidung versehen.

Jedes Hitzeschildelement 155 ist arbeitsmediumsseitig mit einer besonders hitzebeständigen Schutzschicht ausgestattet oder aus hochtemperaturbeständigem Material gefertigt. Dies können massive keramische Steine oder Legierungen mit MCrA1X und/oder keramischen Beschichtungen sein. Die Materialien der Brennkammerwand und deren Beschichtungen können ähnlich der Turbinenschaufeln sein.

Aufgrund der hohen Temperaturen im Inneren der Brennkammer 110 kann zudem für die Hitzeschildelemente 155 bzw. für deren Halteelemente ein Kühlsystem vorgesehen sein.

Die Brennkammer 110 ist insbesondere für eine Detektion von Verlusten der Hitzeschildelemente 155 ausgelegt. Dazu sind zwischen der Brennkammerwand 153 und den Hitzeschildelementen 155 eine Anzahl von Temperatursensoren 158 positioniert.

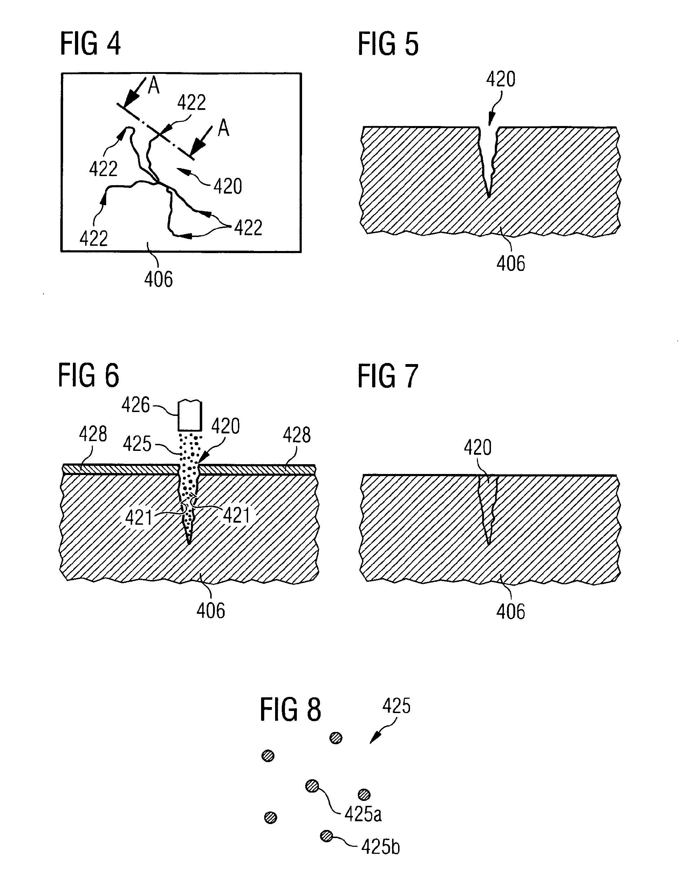

Figur 4 zeigt in einer stark schematisierten Ansicht einen Ausschnitt aus dem Schaufelblatt 406 mit einem verzweigten Riss 420. Das Schaufelblatt 406 ist aus einer einkristallinen Nickel-Basislegierung hergestellt. Grundsätzlich können jedoch auch Bauteile aus anderen einkristallinen Basislegierungen, bspw. Kobalt-Basislegierungen oder Eisen-Basislegierungen mit dem erfindungsgemäßen Verfahren repariert werden. Der Riss 420 weist eine Anzahl von Rissenden 422 auf, in deren Umgebung besonders hohe Spannungen im einkristallinen Basismaterial vorliegen. Die Spannungen können zu einer weiteren Ausdehnung des Risses 420 führen. Es ist daher besonders wichtig, das Fortscheiten des Risses im Bereich der Rissenden 422 zu unterbinden.

Eine Reparatur des Turbinenblattes 406 kann erfolgen, indem der Riss 420 mit einem zum Basismaterial artgleichen Material gefüllt und durch eine geeignete Wärmebehandlung mit dem Basismaterial verbunden wird. Insbesondere wenn dies im Bereich der Rissenden 422 geschieht, ist eine weitere Ausdehnung des Risses wirksam unterbunden und das reparierte Turbinenblatt 406 kann wieder in Betrieb genommen werden.

Damit das reparierte Turbinenblatt 406 die hohen thermischen und mechanischen Beanspruchungen beim Betrieb der Turbine aushalten kann, sollte die Füllung des Risses 420 dieselbe einkristalline Struktur aufweisen, wie das umgebende Basismaterial. Dies kann mit dem nachfolgend beschriebenen Reparaturverfahren erreicht werden.

Figur 5 zeigt in einer schematischen Darstellung eine Schnittansicht des Turbinenblattes 406. Der Schnitt verläuft entlang der Linie A-A in Figur 4. Die Figur zeigt den Riss 420 vor dem Füllen und nach dem Reinigen, wobei sämtliche Oxide von den Risswänden entfernt worden sind. Die Rissreinigung kann durch gängige Reinigungsverfahren erfolgen. Alternativ ist es auch möglich, den Riss 420 mittels eines Erodierstiftes zu weiten.

Der gereinigte Riss 420 wird mit einem zum Basismaterial artgleichen Füllmaterial gefüllt. Der Füllvorgang ist schematisch in Fig. 6 dargestellt. Im vorliegenden Ausführungsbeispiel ist, wie oben erwähnt, das Basismaterial eine Legierung auf Nickelbasis, die unter anderem Aluminium als Zusatz enthält. Als Füllstoff kommen nanoskalige Partikel zur Anwendung, die mittels einer Kaltgas-Spritzpistole 426 in den Riss 420 eingespritzt werden.

Um die nanoskaligen Partikel, die eine Partikelgrößer von weniger als 5 µm und vorzugsweise weniger als 1 µm aufweisen, mittels des Kaltgas-Spritzverfahrens verspritzen zu können, werden sie mit anderen Partikeln zu Agglomeraten 425 zusammengelagert. Die Agglomerate besitzen dann den nötigen Querschnitt, um vom Kaltgasstrom, bspw. einem Heliumstrom, in Richtung auf den Riss 420 mitgerissen zu werden. Ein derartiges Agglomerat ist beispielhaft in Figur 8 dargestellt. Das Agglomerat 425 umfasst im vorliegenden Ausführungsbeispiel ein zentrales nanoskaliges Aluminiumteilchen 425a, um das herum nanoskalige Nickelteilchen 425b angelagert sind. Der Zusammenhalt des Agglomerats wird durch elektrostatische Kräfte bewirkt. Die Nickelteilchen 425b bilden eine Hülle um das Aluminiumteilchen 425a, sodass der Durchmesser des Agglomerats mindestens 5 µm beträgt. Der Querschnitt des Agglomerats ist dann groß genug, um vom Heliumstrom mitgerissen zu werden. Beim Auftreffen auf die Risswand 421 zerfällt das Agglomerat 425 in seine Bestandteile.

Beim Füllen des Risses 420 sind diejenigen Oberflächenbereiche des Schaufelblattes 406, in denen kein Riss 420 vorliegt, mittels einer Maske 428 abgedeckt, um an diesen Stellen kein Material aufzutragen.

Nachdem der Riss 420 vollständige mit den nanoskaligen Partikeln gefüllt ist, erfolgt eine Wärmebehandlung, deren Temperaturen und Haltezeiten derart an das Basismaterial angepasst sind, dass sowohl eine epiktaktische Anbindung des Füllmaterials an die Risswand 421 als auch die notwendige Interdiffusion der Partikel des Füllmaterialgemisches erfolgt. Aufgrund der geringen Partikeldurchmesser ist der Schmelzpunkt der Partikel herabgesetzt, sodass die bei der Wärmebehandlung notwendigen Temperaturen unterhalb des Schmelzpunktes des umgebenden Basismaterials des Schaufelblattes 406 liegen. Die Abkühlung des Bauteils erfolgt so langsam, dass ein geordnetes Wachstum der Kristallstruktur des Materials in der Reparaturstelle nicht behindert wird.

Auf diese Weise kann mit Temperaturen unterhalb der Schmelztemperatur des Basismaterials des Schaufelblattes 406 eine epiktaktische Anbindung des Füllmaterials an das Basismaterial erfolgen, sodass das Füllmaterial die Kristallstruktur des umgebenden Basismaterials weiterführt. Im Ergebnis erhält man den in Figur 7 dargestellten gefüllten Riss 420', in welchem das Füllmaterial zusammen mit dem umgebenden Basismaterial eine einkristalline Struktur bildet.

In einer besonders vorteilhaften Ausgestaltung des Verfahrens ist die Zusammensetzung der Agglomerate 425, d.h. das Verhältnis von Hüllenteilchenzahl zu einem zentralen Teilchen, so gewählt, dass das Füllmaterial in einer eutektischen Mischung vorliegt. Dies führt dazu, dass das Füllmaterial beim Wiedererstarren nach dem Aufschmelzen währen der Wärmebehandlung einen Mischkristall bildet. Zudem ist die Schmelztemperatur einer eutektischen Mischung im Vergleich zu einer Mischung mit denselben Bestandteilen aber anderen Mischungsverhältnissen die niedrigste mögliche Schmelztemperatur der Mischung. Wenn das Füllmaterial dieselben Bestandteile wie das umgebende Basismaterial enthält und in einem eutektischen Mischungsverhältnis vorliegt, liegt seine Schmelztemperatur daher besonders weit unter der Schmelztemperatur des umgebenden Basismaterials.

Das geschilderte Verfahren kann insbesondere dazu Verwendung finden, den Riss 420 im Bereich der Enden 422 so zu füllen, dass die einkristalline Struktur des umgebenden Basismaterials weitergeführt wird. Auf diese Weise können die Spannungen im Basismaterial im Bereich der Rissenden 422 deutlich reduziert werden, sodass ein Fortschreiten des Risses 420 wirksam unterbunden werden kann. Die übrigen Bereiche des Risses können dann auch mit gröberen als nanoskaligen Partikeln gefüllt werden, mit denen nicht ohne weiteres die einkristalline Struktur des Basismaterials fortgeführt werden kann. Wichtig ist in diesem Zusammenhang vor allem, dass mittels der nanoskaligen Partikel die Rissenden 422 zuverlässig gefüllt werden können.

## Patentansprüche

1. Verfahren zum Reparieren eines Bauteils (406), insbesondere eines Gasturbinenbauteils,
welches aus einem Basismaterial mit einer gerichteten Mikrostruktur hergestellt ist, mit den Schritten:
- Reinigen der Reparaturstelle (420),
- Füllen der Reparaturstelle (420) mit einem der Zusammensetzung des Basiswerkstoffes entsprechenden Füllmaterial,
- Durchführen einer Wärmebehandlung im Bereich der gefüllten Reparaturstelle (420),
wobei
- das Füllmaterial mikro- und/oder nanoskalige Partikel (425a, 425b) aufweist,
- beim Füllen der Reparaturstelle (420) Maßnahmen getroffen sind, welche die Oxidation des Füllmaterials verhindern, und
- die Temperaturen und Haltezeiten der Wärmebehandlung derart auf die Zusammensetzung des Füllmaterials und des Basismaterials des Bauteils (406) abgestimmt sind, dass eine epitaktische Anbindung des Füllmaterials an das umgebende Basismaterial erfolgt.

2. Verfahren nach Anspruch 1,
**dadurch gekennzeichnet, dass**
zum Füllen der Reparaturstelle (420) ein Spritzverfahren zur Anwendung kommt, das eine niedrige Temperatur der verspritzten Partikel ermöglicht.

3. Verfahren nach Anspruch 2,
**dadurch gekennzeichnet, dass**
zum Füllen der Reparaturstelle (420) ein Kaltgas-Spritz-Verfahren zur Anwendung kommt.

4. Verfahren nach Anspruch 3,
**dadurch gekennzeichnet, dass**
die Partikel (425a) beim Füllen der Reparaturstelle von einer Hülle (425b) umgeben sind.

5. Verfahren nach Anspruch 4,
**dadurch gekennzeichnet, dass**
die Hülle aus einem Bestandteil des Basismaterials aufgebaut ist.

6. Verfahren nach einem der vorangehenden Ansprüche,
**dadurch gekennzeichnet, dass**
beim Füllen der Reparaturstelle (420) eine nicht zu füllende Bereiche abdeckende Blende (428) zur Anwendung kommt.

7. Verfahren nach einem der vorangehenden Ansprüche,
**dadurch gekennzeichnet, dass**
das Füllmaterial wenigstens zwei Materialbestandteile mit einem eutektischen Mischungsverhältnis aufweist.

8. Verfahren nach einem der vorangehenden Ansprüche,
**dadurch gekennzeichnet, dass**
das Reinigen ein Entfernen sämtlicher Oxide von der Reparaturstelle (420) umfasst.

9. Verfahren nach einem der vorangehenden Ansprüche,
**dadurch gekennzeichnet, dass**
ein Riss (420) im Basismaterial als Reparaturstelle repariert wird und das Füllen des Risses derart erfolgt, dass ein Rissende (422) mit mikro- oder nanoskaligen Partikeln gefüllt wird.
